# EUROPEAN PATENT APPLICATION

(11) **EP 4 836 039 A1**
(43) Date of publication of application: **04.11.2026**
(21) Application number: 24934262.7
(22) Date of filing: 12.11.2024
(51) Int. Cl.: H01M 8/1051, H01M 8/1067, H01M 8/1004, C23C 16/44, C23C 16/40, C23C 16/32, H01M 8/10

(54) **RADICAL SCAVENGER, MANUFACTURING METHOD THEREFOR, MEMBRANE-ELECTRODE ASSEMBLY, AND FUEL CELL**

(30) Priority: 03.04.2024 KR 20240045238; 08.11.2024 KR 20240158089
(71) Applicant: Kolon Industries, Inc., Seoul 07793 (KR)
(72) Inventor: KIM, Jung Ho, Seoul 07793 (KR); KIM, Jun Young, Seoul 07793 (KR); SONG, Kah Young, Seoul 07793 (KR); KONG, Nak Won, Seoul 07793 (KR); LEE, Eun Su, Seoul 07793 (KR); KIM, Hyeong Su, Seoul 07793 (KR); NAM, Kyoung Sik, Seoul 07793 (KR); PARK, Chan Mi, Seoul 07793 (KR); LEE, Ju Sung, Seoul 07793 (KR)
(74) Representative: Vossius & Partner Patentanwälte Rechtsanwälte mbB
(86) International application number: PCT/KR2024/017847
(87) International publication number: WO 2025/211527

(57) **Abstract**

Disclosed are a radical scavenger for improving durability, a membrane-electrode assembly, a fuel cell, and methods for manufacturing the foregoing. According to one aspect, provided is a radical scavenger comprising radical-scavenging particles and a protective layer formed on the surfaces of the radical-scavenging particles, wherein a ratio of the standard deviation of thickness to the average thickness of the protective layer is 5 % or less.

## Description

### Technical Field

The present disclosure relates to a radical scavenger, a fuel cell element/component including the same, and a method for producing the same, and more specifically, to a radical scavenger having a protective layer, a membrane-electrode assembly including the same, a fuel cell, and a method for producing the same.

### Background Art

Fuel cells are power generation systems that convert chemical energy generated by an electrochemical reaction between a fuel (hydrogen, methanol, etc.) and an oxidant (oxygen, air, etc.) into electrical energy. These fuel cells have been studied as a next-generation energy source due to their high energy efficiency and eco-friendly characteristics with low pollutant emissions. Fuel cells selected from among fuel cells for high-temperature operation and low-temperature operation depending on the application field may be used, and the fuel cells may be classified according to the type of electrolyte. Fuel cells for high-temperature operation include solid oxide fuel cells (SOFCs), molten carbonate fuel cells (MCFCs), etc., and fuel cells for low-temperature operation, including alkaline fuel cells (AFCs) and polymer electrolyte membrane fuel cells (PEMFCs), have been typically developed.

Polymer electrolyte fuel cells are attracting attention as portable, automotive, and home power supply devices due to their advantages, such as a low operating temperature of less than 100°C, the elimination of leakage problems caused by the use of solid electrolytes, fast start-up and response characteristics, and excellent durability. In particular, they have been studied as portable fuel cells, because they are high-output fuel cells having a high current density compared to other types of fuel cells and can be miniaturized.

The polymer electrolyte fuel cells may have a unit cell structure in which an anode and a cathode are applied to both sides of an electrolyte membrane composed of polymer material, respectively, and such a structure is referred to as a membrane-electrode assembly (MEA). In other words, the MEA is a place where an electrochemical reaction between hydrogen and oxygen takes place, and may be composed of an anode, a cathode, and a polymer electrolyte membrane placed between them.

Radicals generated at the electrode when the fuel cell is in operation are known to be a major cause of degradation of the polymer electrolyte membrane. Hydrogen peroxide (H₂O₂) may be generated during the oxygen reduction reaction at the cathode, and hydrogen peroxide radicals (hydroperoxyl radicals, OOH·) and hydroxyl radicals (OH·) may be generated from the generated hydrogen peroxide. The radicals generated as described above cause the substantial degradation of the ionomer of the polymer electrolyte membrane, which has hydrogen ion conductivity, thereby lowering the ion conductivity of the polymer electrolyte membrane and ultimately causing deterioration in fuel cell performance.

Accordingly, in order to remove the generated radicals, a method has been proposed to prevent the degradation of the polymer electrolyte membrane and the resulting deterioration in fuel cell performance by adding a material that scavenges radicals, that is, a radical scavenger, to the polymer electrolyte membrane or electrode layer. The radical scavenger plays a role in removing radicals generated at the electrode by reaction with the radicals before the radicals degrade the polymer electrolyte membrane.

However, conventional radical scavengers have poor durability, and thus cannot properly remove radicals if the fuel cell is operated for a long time, which can lead to a rapid decline in fuel cell performance. In addition, conventional radical scavengers have a problem in that the scavenger particles aggregate together, hindering the movement of hydrogen ions and thus lowering the ion conductivity of the polymer electrolyte membrane.

Therefore, there is a need to develop a radical scavenger that may minimize aggregation between its particles while maintaining its radical-scavenging effect for a long period of time and has excellent functionality and production efficiency, and a method for producing the same.

### DISCLOSURE

### Technical Problem

A technical problem to be solved by the present disclosure is to provide a method for producing a radical scavenger that may improve the durability of the radical scavenger, minimize aggregation between radical-scavenging particles, and ensure excellent functionality and production efficiency, and a radical scavenger produced by the method.

Another technical problem to be solved by the present disclosure is to provide a polymer electrolyte membrane having the above-described radical scavenger applied thereto, a membrane-electrode assembly (MEA), and a method for producing the same.

Still another technical problem to be solved by the present disclosure is to provide a fuel cell including the above-described membrane-electrode assembly (MEA) and a method for producing the same.

The problems to be solved by the present disclosure are not limited to the problems mentioned above, and other problems not mentioned will be clearly understood by those skilled in the art from the following description.

### Technical Solution

According to a first aspect of the present disclosure, there is provided a radical scavenger comprising a radical-scavenging particle and a protective layer formed on the surface of the radical-scavenging particle, wherein the ratio of thickness standard deviation to the average thickness of the protective layer is 5% or less.

According to a second aspect of the present disclosure, in the first aspect, the protective layer may comprise a titania layer having a multilayer structure.

According to a third aspect of the present disclosure, in the first or second aspect, the protective layer may comprise at least two of a titania layer, a silica layer, and a carbon-based material layer. Specifically, the protective layer may comprise a titania layer and a silica layer, and more specifically, may comprise the titania layer and the silica layer, which are sequentially stacked. Here, unlike the silica layer, the titania layer has a structure in which multiple particles are clustered. Thus, when the titania layer and the silica layer are sequentially stacked on the surface of the radical-scavenging particle, the stability or durability of the radical-scavenging particle may be further improved.

In some embodiments, the protective layer having a multilayer structure may comprise the titania layer, the silica layer, and the carbon-based material layer, which are sequentially stacked on the surface of the radical-scavenging particle. According to some embodiments of the present disclosure, as the protective layer comprises the titania layer, the silica layer, and the carbon-based material layer, it may not only exhibit a synergistic effect on radical scavenging, but also effectively prevent the excessive aggregation of the radical-scavenging particles and further improve stability.

In some embodiments, the protective layer may have a two-layer structure or a three-layer structure.

According to a fourth aspect of the present disclosure, in any one of the first to third aspects, the protective layer may have a porous structure. For example, the porosity of the protective layer, which is the percentage of pore volume relative to the total volume of the protective layer, may be 1 vol% or more and 15 vol% or less, specifically 1 vol% or more, 2 vol% or more, 3 vol% or more, 4 vol% or more, or 5 vol% or more, and 6 vol% or less, 7 vol% or less, 8 vol% or less, 9 vol% or less, 10 vol% or less, 11 vol% or less, 12 vol% or less, 13 vol% or less, 14 vol% or less, or 15 vol% or less.

According to a fifth aspect of the present disclosure, in any one of the first to fourth aspects, the protective layer may have a thickness of 0.05 nm or more and 20 nm or less. For example, the thickness of the protective layer may be 0.05 nm or more, 0.1 nm or more, 0.5 nm or more, 1.0 nm or more, 1.5 nm or more, 1.9 nm or more, 2.0 nm or more, 2.5 nm or more, 3.0 nm or more, 3.5 nm or more, 3.8 nm or more, or 3.9 nm or more, and 4.0 nm or less, 5 nm or less, 6 nm or less, 7 nm or less, 8 nm or less, 9 nm or less, 10 nm or less, 11 nm or less, 12 nm or less, 13 nm or less, 14 nm or less, 15 nm or less, 16 nm or less, 17 nm or less, 18 nm or less, 19 nm or less, or 20 nm or less, or may be more than or equal to any one of the plurality of lower limits and less than or equal to any one of the plurality of upper limits. At least one of the plurality of material layers described in the present specification may have a thickness within the above-described numerical range.

According to a sixth aspect of the present disclosure, in any one of the first to fifth aspects, the protective layer may be formed using a vapor adsorption method of vaporizing a predetermined precursor and adsorbing the precursor or a component decomposed from the precursor onto the surface of the radical-scavenging particle.

According to a seventh aspect of the present disclosure, there is provided a method for producing a radical scavenger, comprising: a step of providing a radical-scavenging particle; and a step of forming a protective layer from a predetermined precursor on the surface of the radical-scavenging particle using a vapor adsorption method of vaporizing the predetermined precursor and adsorbing the precursor or a component decomposed from the precursor onto the surface of the radical-scavenging particle.

According to an eighth aspect of the present disclosure, in the seventh aspect, the precursor may have a vaporization temperature of about 60°C or higher and 250°C or lower.

According to a ninth aspect of the present disclosure, in the seventh or eighth aspect, the protective layer may comprise at least one of titania, silica, and carbon-based material, specifically two or more of titania, silica, and carbon-based material, more specifically titania and silica or titania, silica, and carbon-based material. Meanwhile, in the field of general fuel cells, titania may be used as a catalyst for electrochemical reactions or may function to enable self-humidification or prevent methanol crossover. In addition, silica may be used as a moisture absorbent, and carbon-based materials may function to stably position functional particles. According to some embodiments of the present disclosure, as the protective layer comprises titania and silica or comprises titania, silica and carbon-based material, it may not only exhibit a synergistic effect on radical scavenging, but also effectively prevent excessive aggregation between the radical-scavenging particles and further improve the stability of the radical scavenger.

According to a tenth aspect of the present disclosure, in the ninth aspect, the carbon-based material may further comprise at least one heteroatom selected from among nitrogen (N), phosphorus (P), and sulfur (S).

According to an eleventh aspect of the present disclosure, in any one of the seventh to tenth aspects, the protective layer may comprise titania, and the precursor may comprise, as a precursor for forming the titania, at least one of titanium tetra-isopropoxide, titanium ethoxide, titanium methoxide, and titanium tetrachloride.

According to a twelfth aspect of the present disclosure, in any one of the seventh to eleventh aspects, the protective layer may comprise silica, and the precursor may comprise, as a precursor for forming the silica, at least one of tetraethyl orthosilicate and tetramethyl orthosilicate.

According to a thirteenth aspect of the present disclosure, in any one of the seventh to twelfth aspects, the protective layer may comprise carbon-based material, and the precursor may comprise, as a precursor for forming the carbon-based material, at least one of phenol-formaldehyde resin, urea-formaldehyde resin, and pyrrole. Alternatively, the precursor may be any one selected from the group consisting of phenol, formaldehyde, urea, pyrrole, and combinations thereof.

According to a fourteenth aspect of the present disclosure, in any one of the seventh to thirteenth aspects, the step of forming the protective layer may comprise: a step of forming a preliminary protective layer from the precursor; and a step of forming the protective layer from the preliminary protective layer by performing a heat treatment process on the preliminary protective layer. In some embodiments, each step of forming the protective layer may be repeated once or multiple times, thereby forming a single-layer or multilayer structure. In some embodiments, the protective layer may comprise a titania layer, and the crystal structure of the titania layer may be controlled according to the temperature of the heat treatment process.

In some embodiments, the protective layer may comprise a carbon-based material layer, and the preliminary protective layer may comprise a polymer material layer, wherein the carbon-based material layer may be formed by carbonizing the polymer material layer through the heat treatment process.

In some embodiments, there may be provided a method for producing a membrane-electrode assembly (MEA), comprising: a step of producing a radical scavenger using the method according to any one of the seventh to thirteenth aspects; and a step of producing a membrane-electrode assembly (MEA) comprising the radical scavenger.

According to a fifteenth aspect of the present disclosure, there is provided a membrane-electrode assembly (MEA) comprising: a first electrode; a second electrode spaced apart from the first electrode; a polymer electrolyte membrane disposed between the first electrode and the second electrode; and a radical scavenger provided on at least one of the first electrode, the second electrode and the polymer electrolyte membrane, wherein the radical scavenger has a feature according to any one of the first to fourteenth aspects.

According to a sixteenth aspect of the present disclosure, in the fifteenth aspect, the membrane-electrode assembly may further comprise an interfacial bonding layer (IBL) disposed in at least one of between the first electrode and the polymer electrolyte membrane and between the second electrode and the polymer electrolyte membrane, wherein the interfacial bonding layer may comprise a radical scavenger having the feature of any one of the first to fourteenth aspects.

According to a seventeenth aspect of the present disclosure, there is provided a fuel cell comprising the membrane-electrode assembly according to the fifteenth or the sixteenth aspect.

### Advantageous Effects

According to one aspect of the present disclosure, it is possible to realize a radical scavenger, which may prevent or minimize aggregation between scavenging particles while having excellent durability, by forming a protective layer with excellent stability on the surface of a radical-scavenging particle to a relatively small thickness using a vapor adsorption method. In addition, it is possible to impart various functionalities (additional characteristics) to the protective layer depending on the type/material and number of layers of the protective layer, and as a result, it is possible to realize a radical scavenger with excellent functionality.

By applying the radical scavenger according to one aspect of the present disclosure, it is possible to produce a membrane-electrode assembly (MEA) with improved durability (chemical durability), stability and performance, as well as a fuel cell including the same.

### Brief Description of Drawings

Fig. 1 illustrates a method for producing a radical scavenger according to one embodiment of the present disclosure and a radical scavenger produced by this method.
Fig. 2 illustrates a method for producing a radical scavenger according to another embodiment of the present disclosure and a radical scavenger produced by this method.
Fig. 3 shows a radical scavenger produced according to one embodiment of the present disclosure.
Fig. 4 is a transmission electron microscope image showing a radical scavenger produced according to one embodiment of the present disclosure.
Fig. 5 is a transmission electron microscope image showing a radical scavenger prepared according to a reference example of the present disclosure.
Fig. 6 shows a radical scavenger produced according to another embodiment of the present disclosure.
Fig. 7 is a transmission electron microscope image showing a radical scavenger produced according to another embodiment of the present disclosure.
Fig. 8 shows a radical scavenger produced according to another embodiment of the present disclosure.
Fig. 9 is a transmission electron microscope image showing a radical scavenger produced according to another embodiment of the present disclosure.
Fig. 10 illustrates a method for producing a radical scavenger according to another embodiment of the present disclosure and a radical scavenger produced by this method.
Fig. 11 is a transmission electron microscope image showing a radical scavenger produced according to another embodiment of the present disclosure.
Fig. 12 illustrates a method for producing a radical scavenger according to another embodiment of the present disclosure and a radical scavenger produced by this method.
Fig. 13 is a cross-sectional view showing a membrane-electrode assembly (MEA) obtained by applying a radical scavenger according to one embodiment of the present disclosure.
Fig. 14 is a cross-sectional view showing a membrane-electrode assembly (MEA) obtained by applying a radical scavenger according to another embodiment of the present disclosure.
Fig. 15 is a cross-sectional scanning electron microscope image of a membrane-electrode assembly (MEA) having an interfacial bonding layer obtained by applying a radical scavenger according to one embodiment of the present disclosure.
Fig. 16 is a cross-sectional scanning electron microscope image of a polymer electrolyte membrane (PEM) obtained by applying a radical scavenger according to one embodiment of the present disclosure.
Fig. 17 illustrates a fuel cell including a membrane-electrode assembly (MEA) obtained by applying a radical scavenger produced according to one embodiment of the present disclosure.

### Best Mode

Hereinafter, embodiments of the present disclosure will be described in detail with reference to the accompanying drawings.

The embodiments of the present disclosure to be described below are provided to more clearly explain the present disclosure to those skilled in the art, and the scope of the present disclosure is not limited by the following embodiments. The following embodiments may be modified in various other forms.

The terms used in the present specification are intended to describe specific embodiments and are not intended to limit the present disclosure. In the present specification, singular expressions include plural expressions unless the context clearly indicates otherwise. In addition, the term "comprise" and/or "comprising" as used in the present specification is intended to denote the existence of stated shapes, steps, numbers, operations, members, elements, and/or combinations thereof, but does not exclude the existence or addition of one or more other shapes, steps, numbers, operations, members, elements, and/or combinations thereof. In addition, the term "connection" as used in the present specification means not only that certain members are connected directly to each other, but also that they are connected indirectly via a third member interposed therebetween.

In the present specification, when any member is referred to as being "on" another member, it refers not only to a case where the member is in contact with the other member, but also to a case where a third member exists between the two members. As used in the present specification, the term "and/or" includes any and all combinations of one or more of the associated listed items. In addition, as used in the present specification, the terms "about" and "substantially" are used in the sense of "at, or nearly at, when given the manufacturing and material tolerances inherent in the stated circumstances" and are used to prevent an unscrupulous infringer from unfairly taking advantage of the present disclosure where exact or absolute figures are stated as an aid to understanding the present disclosure.

In the present specification, the range of numerical values expressed using the term "to" denotes a range of numerical values that includes numerical values described before and after the term as a lower limit value and an upper limit value. For example, if "a to b" is described in the specification, it may be understood that "a or more and b or less (a to b)" is described.

When a plurality of numerical values as the upper and lower limits of an arbitrary numerical range are disclosed in the present specification, the numerical range disclosed in the present specification may be understood as a range of arbitrary numerical values including any one value among the plurality of lower limit values and any one value among the plurality of upper limit values as a lower limit value and an upper limit value, respectively. For example, if "a or more or b or more and c or less or d or less" is described, it may be understood that a or more and c or less, a or more and d or less, b or more and c or less, or b or more and d or less is described.

In the present specification, the term "layer" or "film" may include, when observing a region in which the layer or film exists, not only a case where the layer or film is formed throughout the region, but also a case where the layer or film is formed only in a portion of the region. For example, the surface of the layer or film may be defined as including a flat form, a non-flat form, and a combination thereof; or a continuous form, a discontinuous form, and a combination thereof. For example, when another member is composed of a layer or film formed directly on one member, the coverage of the other member on the surface of the one member may be defined as 1% or more, 5% or more, 10% or more, 20% or more, 30% or more, 40% or more, 50% or more, 60% or more, 70% or more, 80% or more, 85% or more, 90% or more, 95% or more, or 99% or more. For example, even when multiple particles form a clustered structure, this structure may be defined as a "layer".

In the present specification, "or" may be defined to mean "and/or". For example, a or b may be defined as including a or b alone or as including both a and b.

Embodiments of the present disclosure will be described in detail below with reference to the accompanying drawings. The sizes and thicknesses of the regions or parts shown in the accompanying drawings may be somewhat exaggerated for clarity and convenience of description. Throughout the detailed description, like reference numerals indicate like components.

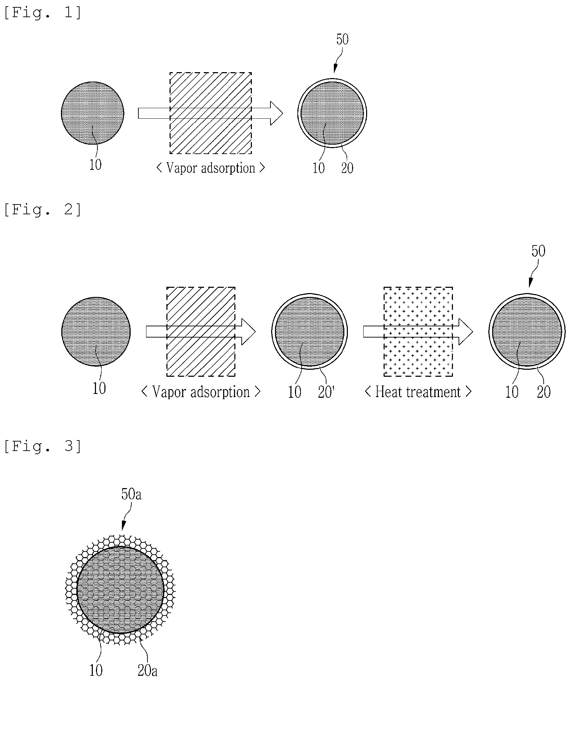

Fig. 1 illustrates a method for producing a radical scavenger according to one embodiment of the present disclosure and a radical scavenger 50 produced by this method.

Referring to Fig. 1, a method for producing a radical scavenger according to one embodiment of the present disclosure may include: a step of providing a radical-scavenging particle 10; and a step of forming a protective layer 20 on the surface of the radical-scavenging particle 10. In the step of forming the protective layer 20, a vapor adsorption method may be used. The protective layer 20 may be considered as a type of coating layer or shell layer. The radical scavenger 50 produced by the method of this embodiment may be considered as a type of "radical scavenger complex" or "radical scavenger complex particle".

As the radical-scavenging particle 10, any particle or additive (particle-type additive) having radical scavenging ability may be used without particular limitation, and any material may be used to form a complex (i.e., 50) in the embodiment of the present disclosure. For example, the radical-scavenging particle 10 may include at least one selected from the group consisting of a transition metal, a noble metal, ions thereof, salts thereof, oxides thereof, nitrides thereof, and complexes thereof.

The transition metal may be cerium (Ce), manganese (Mn), tungsten (W), cobalt (Co), vanadium (V), nickel (Ni), chromium (Cr), zirconium (Zr), yttrium (Y), iridium (Ir), iron (Fe), titanium (Ti), molybdenum (Mo), lanthanum (La), or neodymium (Nd), without being limited thereto. The noble metal may be silver (Ag), platinum (Pt), ruthenium (Ru), palladium (Pd), or rhodium (Rh), without being limited thereto. The salts of the transition metal or precious metal may be carbonates, acetates, chlorides, fluorides, sulfates, phosphates, nitrates, tungstates, hydroxides, ammonium acetate, ammonium sulfate, or acetylacetonates, but these are exemplary and the present disclosure is not limited thereto. Various other radical-scavenging materials may be used.

For example, the radical-scavenging particle 10 may include at least one from the group consisting of cerium oxide, MnO₂, and Pt nanoparticles. Here, the cerium oxide may be ceria, i.e., CeO₂. The radical-scavenging particle 10 may be a particle including ceria or a ceria particle. When the radical-scavenging particle 10 includes ceria or is a ceria particle, it may have relatively good radical-scavenging performance.

Meanwhile, the diameter of the radical-scavenging particle 10 may be about 3 nm to 100 nm, more preferably about 4 nm to 80 nm. However, the above-described diameter range of the radical-scavenging particle 10 is exemplary and may vary depending on the case. The radical-scavenging particle 10 may be a type of nanoparticle (nanoscale particle).

In the step of forming the protective layer 20, the protective layer 20 may be formed on the surface of the radical-scavenging particle 10 from a predetermined precursor using a vapor adsorption method of vaporizing the predetermined precursor and adsorbing the precursor or a component decomposed from the precursor onto the surface of the radical-scavenging particle 10.

By vaporizing the precursor by heating to a predetermined temperature, the precursor (vaporized precursor) or the component decomposed from the precursor (vaporized precursor) may be adsorbed onto the surface of the radical-scavenging particle 10. The above precursor may have a vaporization temperature in the range of, for example, about 60 to 250°C. Any material capable of "vaporization" or "vaporization and decomposition/polymerization" at a temperature in the range of about 60 to 250°C may be used as the precursor.

The protective layer 20 may include at least one of titania, silica, and carbon-based material. The protective layer (20) may include at least one of a titania layer, a silica layer, and a carbon-based material layer. Here, the carbon-based material may further contain at least one heteroatom selected from the group consisting of nitrogen (N), sulfur (S), and the like.

When the protective layer 20 includes titania, for example, when the protective layer 20 is a titania layer, the precursor may include, as a precursor for forming the titania (titania layer), at least one of titanium tetraisopropoxide, titanium ethoxide, and tetraethyl orthotitanate. However, the precursor material for forming titania is not limited to that described above and may vary depending on the case.

When the protective layer 20 includes silica, for example, when the protective layer 20 is a silica layer, the precursor may include, as a precursor for forming the silica (silica layer), at least one of tetraethyl orthosilicate (TEOS) and tetramethyl orthosilicate (TMOS). However, the precursor material for forming silica is not limited to that described above and may vary depending on the case.

When the protective layer 20 includes carbon-based material, for example, when the protective layer 20 is a carbon-based material layer, the precursor may include, as a precursor for forming the carbon-based material (carbon-based material layer), at least one of phenol-formaldehyde resin, urea-formaldehyde resin, and pyrrole. However, the precursor material for forming the carbon-based material is not limited to that described above and may vary depending on the case. Here, when the precursor contains a heteroatom such as nitrogen (N) or sulfur (S), a heteroatom-doped carbon-based material layer may be formed. The carbon-based material layer may be a carbon layer. Accordingly, the protective layer 20 may include a carbon layer or a heteroatom-doped carbon layer.

In the vapor adsorption process, the vaporized precursor or the component decomposed from the vaporized precursor may be adsorbed onto the surface of the radical-scavenging particle 10 to form an adsorbed layer (coating layer). In the vapor adsorption process, a predetermined heat treatment process may be performed simultaneously on the vaporized precursor and the radical-scavenging particle 10, or a predetermined heat treatment process (subsequent heat treatment process) may be performed separately on the adsorbed layer (coating layer) after the vapor adsorption process. Through the heat treatment process and/or the subsequent heat treatment process, the protective layer 20 may be formed more easily, and the material composition, physical properties, crystal structure, porosity, etc. of the protective layer 20 may be controlled.

In some embodiments, pores may be formed in the protective layer 20. The pores may be formed through the heat treatment process and/or the subsequent heat treatment process. For example, the protective layer 20 may have a porous structure. The porosity of the protective layer 20 may be, for example, about 1% to about 15%. The pores may be amorphous pores. The amorphous pores may mostly be micropores with a diameter of less than about 2 nm, and may also include some mesopores with a diameter of about 2 nm or more and less than about 50 nm. When the protective layer 20 has pores, the effect of partially improving the radical-scavenging performance of the radical-scavenging particle 10 may be obtained. For example, the proportion of the micropores relative to a total of 100 vol% of the amorphous pores may be 80 vol% or more, 85 vol% or more, or 90 vol% or more.

According to another aspect of the present disclosure, there is provided a radical scavenger including: a radical-scavenging particle; and a protective layer formed on the surface of the radical-scavenging particle, wherein the ratio of thickness standard deviation to the average thickness of the protective layer is 5% or less. In some examples, the maximum thickness deviation of the protective layer may be analyzed using a transmission electron microscope.

In some embodiments of the present disclosure, the ratio of thickness standard deviation to the average thickness of the protective layer may be 4.5% or less, 4.0% or less, 3.5% or less, 3.0% or less, 2.5% or less, 2.0% or less, 1.98% or less, 1.9% or less, 1.87% or less, 1.8% or less, 1.74% or less, 1.7% or less, 1.6% or less, 1.59% or less, 1.57% or less, 1.40% or less, 1.30% or less, 1.28% or less, or 0.5% or more and equal to or less than any one of the plurality of upper limits. If the ratio of thickness standard deviation to the average thickness of the protective layer is outside the above numerical range, a problem may arise in that the protective layer is not uniformly formed or the formed protective layer is bulky. For this reason, a problem may arise in that the function of the radical scavenger is degraded, and thus, even when the radical scavenger is applied to an electrolyte membrane or an electrode, the chemical durability thereof may not be sufficiently exhibited. Here, the ratio of thickness standard deviation to the average thickness of the protective layer may be achieved by independently controlling the type of precursor, the content of the precursor, the vapor adsorption method, or the process conditions of the vapor adsorption method.

Since the protective layer 20 is formed using the above-described vapor adsorption method, it may be easily formed to have a relatively small thickness. The thickness of the protective layer 20 may be about 0.05 nm to 20 nm. For example, the thickness of the protective layer 20 may be about 0.05 to 10 nm or about 0.05 to 5 nm. In an embodiment of the present disclosure, the formation of a bulky protective layer may be suppressed (minimized) or prevented.

According to an embodiment of the present disclosure, as the protective layer 20 is formed using the above-described vapor adsorption method, the protective layer 20 having excellent film quality and a relatively small thickness may be easily formed. In addition, aggregation between radical scavengers 50 (i.e., composite particles) may be suppressed or minimized. By forming the protective layer 20 with excellent film quality and stability on the surface of the radical-scavenging particles 10 to a relatively small thickness using the above-described vapor adsorption method, it is possible to realize the radical scavenger 50 that may prevent or minimize aggregation between particles while having excellent durability. In addition, depending on the type/material and number of layers of the protective layer 20, various functionalities (additional characteristics) may be imparted to the protective layer 20, and as a result, the radical scavenger 50 with excellent functionality may be realized.

Fig. 2 illustrates a method for producing a radical scavenger according to another embodiment of the present disclosure and a radical scavenger 50 produced by this method.

Referring to Fig. 2, a method for producing a radical scavenger according to an embodiment of the present disclosure may include: a step of providing a radical-scavenging particle 10; a step of forming a preliminary protective layer 20' on the surface of the radical-scavenging particle 10 from a precursor using a vapor adsorption method; and a step of forming a protective layer 20 from the preliminary protective layer 20' by performing a heat treatment process on the preliminary protective layer 20'. The vapor adsorption method used to form the preliminary protective layer 20' may be the same as or similar to that described with reference to Fig. 1. Therefore, the vapor adsorption method described with reference to Fig. 1 may be applied to Fig. 2 in a non-contradictory manner. The heat treatment process may be performed, for example, at a temperature of about 800 to 2,400°C.

When the protective layer 20 is a titania layer or includes a titania layer, the crystal structure of the titania layer may be controlled according to the temperature of the heat treatment process. Accordingly, in this regard, the characteristics of the protective layer (20) may be easily controlled.

Meanwhile, when the protective layer 20 is a carbon-based material layer or includes a carbon-based material layer, the preliminary protective layer 20' may be a polymer material layer or include a polymer material layer. In this case, the carbon-based material layer may be formed from the polymer material layer by carbonizing the polymer material layer through the heat treatment process. Additionally, if necessary, a graphitization process may be further performed on the carbon-based material layer.

According to an embodiment of the present disclosure, the protective layer 20 with controlled characteristics may be more easily formed through a vapor adsorption process and a subsequent heat treatment process.

Fig. 3 shows a radical scavenger produced according to one embodiment of the present disclosure.

Referring to Fig. 3, a radical scavenger 50a may include a radical-scavenging particle 10 and a protective layer 20a formed on the surface of the radical-scavenging particle. The protective layer 20a may be formed using a vapor adsorption process. A precursor of a carbon-based material may be applied to the vapor adsorption process. Therefore, in this embodiment, the protective layer 20a may be a carbon-based material layer (e.g., a carbon layer).

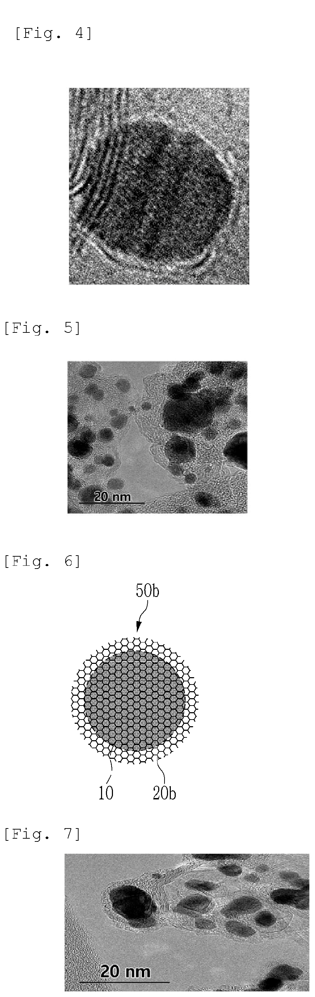

Fig. 4 is an electron microscope image showing a radical scavenger produced according to one embodiment of the present disclosure.

Referring to Fig. 4, the produced radical scavenger (composite particle) has the same configuration as shown in Fig. 3. The protective layer of the radical scavenger (composite particle) is a carbon-based material layer (carbon layer) formed by a vapor adsorption process using phenol-formaldehyde (a type of phenolic resin) as a precursor of the carbon-based material.

Fig. 5 is an electron microscope image showing a radical scavenger produced according to a reference example of the present disclosure.

Referring to Fig. 5, the produced radical scavenger (composite particle) has the same configuration as shown in Fig. 3. The protective layer of the radical scavenger (composite particle) is a carbon-based material layer (carbon layer) formed using a hydrothermal reaction process in a solvent by applying phenol-formaldehyde (a type of phenolic resin) as a precursor of the carbon-based material.

Fig. 6 shows a radical scavenger produced according to another embodiment of the present disclosure.

Referring to Fig. 6, a radical scavenger 50b may include a radical-scavenging particle 10 and a protective layer 20b formed on the surface of the radical-scavenging particle. The protective layer 20b may be formed using a vapor adsorption process. A silica precursor may be applied to the vapor adsorption process. Therefore, in this embodiment, the protective layer 20b may be a silica layer.

Fig. 7 is an electron microscope image showing a radical scavenger produced according to another embodiment of the present disclosure.

Referring to Fig. 7, the produced radical scavenger (composite particle) has the same configuration as shown in Fig. 5. The protective layer of the radical scavenger (composite particle) is a silica layer formed by a vapor adsorption process using tetraethyl orthosilicate (TEOS) as a silica precursor.

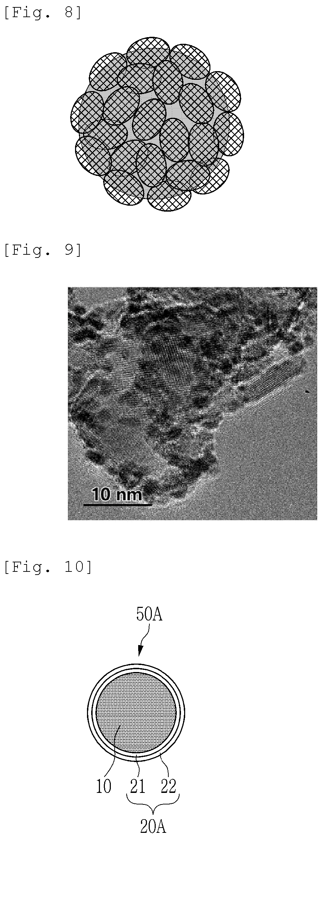

Fig. 8 shows a radical scavenger produced according to another embodiment of the present disclosure.

Referring to Fig. 8, a radical scavenger 50c may include a radical-scavenging particle 10 and a protective layer 20c formed on the surface of the radical-scavenging particle. The protective layer 20c may be formed using a vapor adsorption process. A titania precursor may be applied to the vapor adsorption process. Therefore, in this embodiment, the protective layer 20c may be a titania layer.

Fig. 9 is a transmission electron microscope image showing a radical scavenger produced according to another embodiment of the present disclosure.

Referring to Fig. 9, the produced radical scavenger (composite particle) has the same configuration shown in Fig. 7. The protective layer of the radical scavenger (composite particle) is a titania layer formed by a vapor adsorption process using titanium tetraisopropoxide as a titania precursor. Due to the characteristics of titania, the titania protective layer forms a protective layer in the form of a particle with a size of 0.05 to 20 nm.

Fig. 10 illustrates a method for producing a radical scavenger according to another embodiment of the present disclosure and a radical scavenger 50A produced by this method.

Referring to Fig. 10, the radical scavenger 50A according to this embodiment may include a radical-scavenging particle 10 and a protective layer 20A formed on the surface of the radical-scavenging particle. The protective layer 20A may be formed using a vapor adsorption process.

The protective layer 20A may have a multilayer structure including at least two different material layers 21, 22. This embodiment shows a case where the protective layer 20A has a two-layer structure including a first material layer 21 and a second material layer 22. The first material layer 21 and the second material layer 22 may be sequentially formed (stacked) on the surface of the radical-scavenging particle 10.

According to one embodiment, the protective layer 20A may include a titania layer. In addition, the protective layer 20A may include two material layers selected from a titania layer, a silica layer, and a carbon-based material layer. As a specific example, the first material layer 21 may be a titania layer, and the second material layer 22 may be any one of a silica layer and a carbon-based material layer.

Each of the first and second material layers 21, 22 constituting the protective layer 20A may be formed using the method described with reference to Figs. 1 and 2. Each of the first and second material layers 21, 22 may have a thickness of about 0.05 to 20 nm, or about 0.05 to 10 nm, or about 0.05 to 5 nm.

When the protective layer 20A has a multilayer structure as shown in Fig. 10, the durability and stability of the radical scavenger 50A may be further improved. In addition, the characteristics of the radical scavenger 50A may be improved by the functionality (different functionality) of each of the first and second material layers 21, 22.

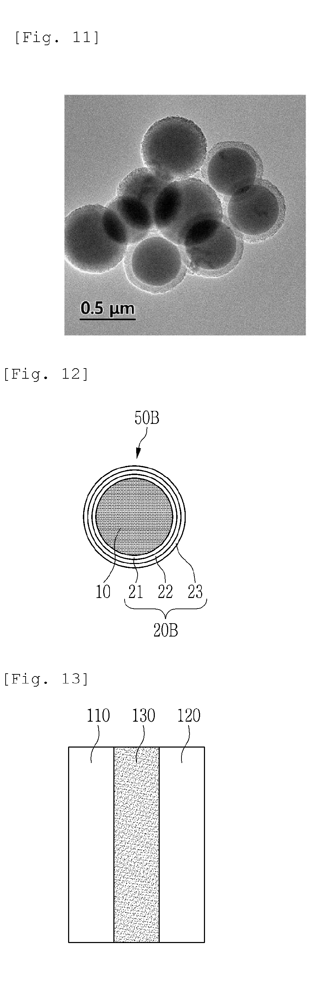

Fig. 11 is a transmission electron microscope image showing a radical scavenger produced according to another embodiment of the present disclosure.

Referring to Fig. 11, the produced radical scavenger (composite particle) has the same configuration as shown in Fig. 9. The first material layer of the protective layer of the radical scavenger (composite particle) is a titania layer formed by a vapor adsorption process using titanium tetraisopropoxide as a titania precursor. Due to the characteristics of titania, the titania protective layer forms a protective layer in the form of a particle with a size of 0.05 to 20 nm. The second material layer of the protective layer of the radical scavenger (composite particle) is a silica layer formed by a vapor adsorption process using TEOS as a silica precursor.

Fig. 12 illustrates a method for producing a radical scavenger according to another embodiment of the present disclosure and a radical scavenger produced by this method.

Referring to Fig. 12, a radical scavenger 50B according to the present embodiment may include a radical-scavenging particle 10 and a protective layer 20B formed on the surface of the radical-scavenging particle. The protective layer 20B may be formed using a vapor adsorption process.

The protective layer 20B may have a multilayer structure including at least two different material layers 21, 22, 23. This embodiment shows a case where the protective layer 20B has a three-layer structure including a first material layer 21, a second material layer 22, and a third material layer 23. The first material layer 21, the second material layer 22, and the third material layer 23 may be sequentially formed (stacked) on the surface of the radical-scavenging particle 10.

According to one embodiment, the protective layer 20B may include a titania layer. Additionally, the protective layer 20B may include at least two material layers selected from among a titania layer, a silica layer, and a carbon-based material layer. As a specific example, the first material layer 21 may be a titania layer, the second material layer 22 may be a silica layer, and the third material layer 23 may be a carbon-based material layer.

Each of the first to third material layers 21, 22, 23 constituting the protective layer 20B may be formed using the method described with reference to Figs. 1 and 2. Each of the first to third material layers 21, 22, 23 may have a thickness of about 0.05 to 20 nm, or about 0.05 to 10 nm, or about 0.05 to 5 nm.

When the protective layer 20B has a multilayer structure as shown in Fig. 12, the durability and stability of the radical scavenger 50B may be further improved. In addition, the characteristics of the radical scavenger 50B may be improved by the functionality (different functionality) of each of the first to third material layers 21, 22, 23. In particular, when the protective layer 20B has a three-layer structure as shown in Fig. 12, the characteristics of the radical scavenger 50B may be significantly improved in various aspects. Additionally, the protective layer of the radical scavenger according to an embodiment of the present disclosure may also have a multilayer structure consisting of three or more layers.

Fig. 13 is a cross-sectional view showing a membrane-electrode assembly (MEA) including a radical scavenger according to one embodiment of the present disclosure.

Referring to Fig. 13, a membrane-electrode assembly (MEA) according to some embodiments of the present disclosure may include a first electrode 110, a second electrode 120 spaced apart from the first electrode 110, and a polymer electrolyte membrane 130 disposed between the first electrode 110 and the second electrode 120. Additionally, the membrane-electrode assembly (MEA) may include radical scavengers (a plurality of particles) (not shown) provided inside at least one of the first electrode 110, the second electrode 120, and the polymer electrolyte membrane 130 or between them. Here, the radical scavengers may have the same configuration as described with reference to Figs. 1 to 11 and may be produced according to the production method described above.

The first electrode 110 may be an oxidation electrode, and the second electrode 120 may be a reduction electrode. The first electrode 110 may be or include a first electrode catalyst layer, and the second electrode 120 may be or include a second electrode catalyst layer. The radical scavenger may be applied to at least one of the first and second electrode catalyst layers. As the materials for each of the first electrode 110, the second electrode 120, and the polymer electrolyte membrane 130, the corresponding constituent materials of conventional membrane-electrode assemblies (MEAs) for fuel cells may be applied.

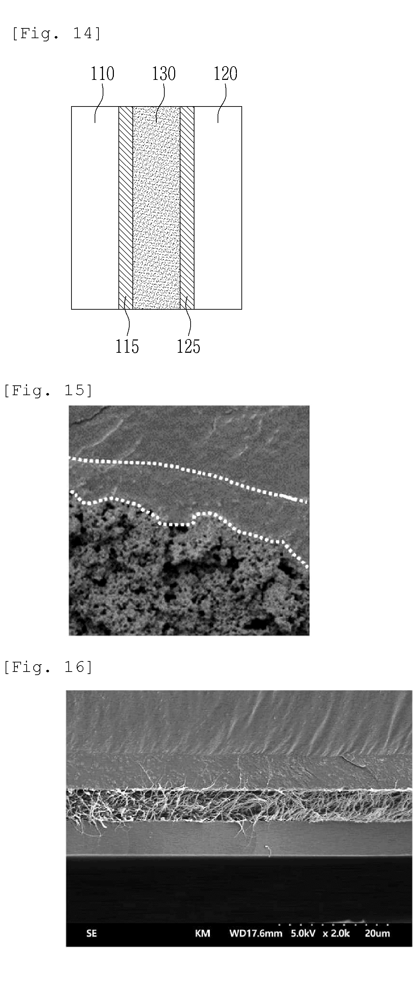

Fig. 14 is a cross-sectional view showing a membrane-electrode assembly (MEA) including a radical scavenger according to another embodiment of the present disclosure.

Fig. 15 is a cross-sectional scanning electron microscope image of a membrane-electrode assembly having an interfacial bonding layer including a radical scavenger according to one embodiment of the present disclosure.

Referring to Figs. 14 and 15, a membrane-electrode assembly (MEA) according to some embodiments of the present disclosure may include a first electrode 110, a second electrode 120 spaced apart from the first electrode 110, and a polymer electrolyte membrane 130 disposed between the first electrode 110 and the second electrode 120. Additionally, the membrane-electrode assembly (MEA) may further include interfacial bonding layers (IBLs) 115, 125 disposed between the first electrode 110 and the polymer electrolyte membrane 130 and between the second electrode 120 and the polymer electrolyte membrane 130, respectively. Here, a case is illustrated in which a first interfacial bonding layer 115 is disposed between the first electrode 110 and the polymer electrolyte membrane 130, and a second interfacial bonding layer 125 is disposed between the second electrode 120 and the polymer electrolyte membrane 130.

According to some embodiments of the present disclosure, the membrane-electrode assembly (MEA) may include radical scavengers (a plurality of particles) (not shown) provided inside at least one of the first electrode 110, the first interfacial bonding layer 115, the second electrode 120, the second interfacial bonding layer 125, and the polymer electrolyte membrane 130 or between them. Accordingly, at least some of the radical scavengers may be provided inside at least one of the first and second interfacial bonding layers 115, 125. Here, the radical scavengers may have the same configuration as described with reference to Figs. 1 to 12 and may be produced according to the production method described above.

Meanwhile, the interfacial bonding layer 115, 125 may include an ionomer, and may function to allow the membrane-electrode assembly (MEA) to have low hydrogen permeability without a decrease in ion conductivity and improve the interfacial adhesion between the electrode 110, 120 and the polymer electrolyte membrane 130, thereby improving the durability of the membrane-electrode assembly (MEA).

A method for producing a membrane-electrode assembly (MEA) according to an embodiment of the present disclosure may include: a step of producing a radical scavenger using the same method described with reference to Figs. 1 to 12; and a step of producing a membrane-electrode assembly (MEA) including the radical scavenger. The membrane-electrode assembly (MEA) produced as described above may have the same configuration as described with reference to Figs. 13 and 14.

Fig. 16 is a cross-sectional view showing a polymer electrolyte membrane (PEM) including a radical scavenger according to one embodiment of the present disclosure.

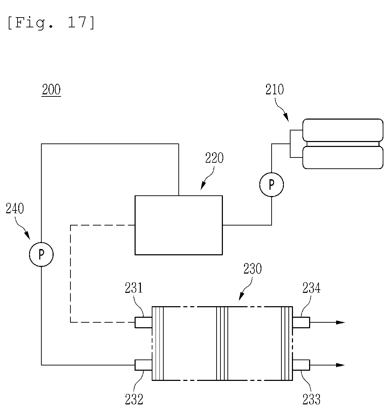

Fig. 17 illustrates a fuel cell 200 including a membrane-electrode assembly (MEA) including a radical scavenger produced according to one embodiment of the present disclosure.

Referring to Fig. 17, a fuel cell 200 according to an embodiment of the present disclosure may include: a fuel supply unit 210 configured to supply a mixed fuel composed of fuel and water; a reforming unit 220 configured to reform the mixed fuel to generate a reformed gas containing hydrogen gas; a stack 230 configured to generate electrical energy by inducing an electrochemical reaction between the reformed gas containing hydrogen gas supplied from the reforming unit 220 and an oxidant; and an oxidant supply unit 240 configured to supply an oxidant to the reforming unit 220 and the stack 230.

The stack 230 may have a plurality of unit cells that generate electrical energy by inducing an oxidation/reduction reaction between a reformed gas containing hydrogen gas supplied from the reforming unit 220 and an oxidant supplied from the oxidant supply unit 240.

The unit cell means a unit cell that generates electricity, and may include a membrane-electrode assembly that oxidizes/reduces a reformed gas containing hydrogen gas and the oxygen of the oxidant, and separator plates (also called bipolar plates, hereinafter referred to as "separator plates") for supplying the reformed gas containing hydrogen gas and the oxidant to the membrane-electrode assembly. The separator plates are disposed on both sides of the membrane-electrode assembly. At this time, the separator plates located at the outermost sides of the stack, respectively, are also specifically referred to as end plates.

Among the separator plates, any one end plate may include a pipe-shaped first supply tube 231 for injecting a reformed gas containing hydrogen gas supplied from the reforming unit 220, and a pipe-shaped second supply tube 232 for injecting oxygen gas, and the other end plate may include a first discharge tube 233 for discharging the remaining unreacted reformed gas containing hydrogen gas from the plurality of unit cells to the outside, and a second discharge tube 234 for discharging the remaining unreacted oxidant from the unit cells to the outside.

In the fuel cell according to an embodiment of the present disclosure, the membrane-electrode assembly included in the stack 230 may have the same configuration as described with reference to Figs. 13 and 14. Although the configuration of the fuel cell is specifically illustrated and described in Fig. 17, this configuration is merely illustrative and may vary depending on the case.

According to the embodiment of the present disclosure described above, it is possible to realize a radical scavenger, which may prevent or minimize aggregation between scavenging particles while having excellent durability, by forming a protective layer with excellent stability on the surface of a radical-scavenging particle to a relatively small thickness using a vapor adsorption method. In addition, it is possible to impart various functionalities (additional characteristics) to the protective layer depending on the type/material and number of layers of the protective layer, and as a result, it is possible to realize a radical scavenger with excellent functionality. By applying the radical scavenger according to one embodiment of the present disclosure, it is possible to produce a membrane-electrode assembly (MEA) with improved durability (chemical durability), stability and performance, as well as a fuel cell including the same.

### Mode for Invention

Hereinafter, examples of the present disclosure will be described in more detail so that a person skilled in the art to which the present disclosure pertains can easily carry out the present disclosure. However, this is nothing but a mere example, and the scope of rights of the present disclosure is not limited by the following contents.

### [Production Example 1: Production of Radical Scavengers]

### <Comparative Example: Commercial Radical Scavenger without Protective Layer>

CeO₂ with an average diameter (D₅₀) of 50 nm was prepared.

### <Example 1-1: Radical Scavenger Including Carbon Protective Layer>

80 parts by weight of phenol (Aldrich) and 70 parts by weight of para-formaldehyde were placed at the bottom of a vacuum infiltration chamber with a mesh in the middle, and 100 parts by weight of CeO₂ with an average diameter (D₅₀) of 50 nm were placed at the top of the vacuum infiltration chamber. Then, heating and vaporization in the chamber was performed at 150°C for 30 minutes, thereby forming a preliminary carbon protective layer with a thickness of 4 nm on the surface of CeO₂ by a vapor adsorption method.

CeO₂ having the preliminary carbon protective layer formed thereon was heat-treated using a tube-type electric furnace as a heat treatment device at 1,000°C for 60 minutes to form a carbon protective layer (thickness: 3.8 nm; porosity 5 vol%) on the surface of CeO₂. Here, the porosity of the carbon protective layer refers to the percentage of pore volume relative to the total volume of the carbon protective layer. The pore volumes before and after heat treatment were analyzed using the BET nitrogen adsorption/desorption measurement method.

### <Example 1-2: Radical Scavenger Including Carbon Protective Layer>

A radical scavenger was produced in the same manner as in Example 1-1, except that MnO₂ with a size of 50 nm was used instead of CeO₂, and that a preliminary carbon protective layer with a thickness of 4 nm was formed on the surface of MnO₂, and then a carbon protective layer (thickness: 3.8 nm; porosity 5 vol%) was formed on the surface of MnO₂ through heat treatment.

### <Example 1-3: Radical-Scavenging Pt Nanoparticles Including Carbon Protective Layer>

A radical scavenger was produced in the same manner as in Example 1-1, except that Pt nanoparticles with a size of 20 nm were used instead of CeO₂, and that a preliminary carbon protective layer with a thickness of 2 nm was formed on the surface of the Pt nanoparticles, and then a carbon protective layer (thickness: 1.9 nm; porosity 3 vol%) was formed on the surface of the Pt nanoparticles through heat treatment.

### <Example 2: Radical Scavenger Including Silica Protective Layer>

A radical scavenger was produced in the same manner as in Example 1-1, except that 150 parts by weight of tetraethyl orthosilicate (silica precursor) was used instead of the phenol-formaldehyde resin precursor, and that, in the vapor adsorption method, the heating temperature and heating time were changed to 100°C and 30 minutes, and the heat treatment temperature and heat treatment time were changed to 550°C and 100 minutes. As a result, a silica protective layer with a thickness of 4 nm and a porosity of 2 vol% was formed.

### <Example 3: Radical Scavenger Including Titania Protective Layer>

A radical scavenger was produced in the same manner as in Example 1-1, except that 130 parts by weight of titanium tetraisopropoxide was used instead of the phenol-formaldehyde resin precursor, and that, in the vapor adsorption method, the heating temperature and heating time were changed to 130°C and 30 minutes, and the heat treatment temperature and heat treatment time were changed to 600°C and 60 minutes. As a result, a titania protective layer with a thickness of 8 nm and a porosity of 10 vol% was formed.

Meanwhile, analysis by transmission electron microscopy (TEM) revealed that the titania protective layer was composed of a cluster of particles with an average diameter of 3 nm.

### <Example 4: Radical Scavenger Including Titania-Silica Protective Layer>

A radical scavenger produced in the same manner as in Example 3, except that 60 parts by weight of titanium tetraisopropoxide was used, was placed in a chamber, and then, based on 100 parts by weight of CeO₂ having the titania layer formed thereon, 100 parts by weight of tetraethyl orthosilicate (silica precursor) was heated and vaporized in the chamber at 100°C for 20 minutes, and then heat-treated at 600°C for 60 minutes to form a titania-silica protective layer. As a result, analysis by transmission electron microscope (TEM) revealed that the titania layer had a thickness of 6 nm (a cluster of particles with an average diameter of 2 nm), the silica layer had a thickness of 3 nm, and the porosity of the titania-silica layer was 4 vol% of the total volume of the protective layer.

### <Reference Example: Production of Radical Scavenger Having Carbon Protective Layer Formed by Conventional Method>

A radical scavenger was produced in the same manner as in Example 1-1, except that a protective layer was formed using a method that does not include the vapor adsorption method, unlike in Example 1-1.

Specifically, a dispersion was prepared by adding the same amount of radical scavenger (CeO₂) as in Example 1-1 and the same amount of polymer precursor (phenol and para-formaldehyde) as in Example 1-1 to a solvent (water). A radical scavenger of the Reference Example was produced in the same manner as in Example 1-1, except that the dispersion was heated at 150°C for 30 minutes to induce a polymerization reaction.

### [Experimental Example 1: Ratio of Thickness Standard Deviation to Average Thickness of Protective Layer of Radical Scavenger]

For each of the radical scavengers produced by the methods according to the Reference Example and Examples 1-1 to 1-3 and 2, the ratio of thickness standard deviation to the average thickness of the protective layer was measured using a transmission electron microscope. Specifically, after selecting five random points on the sample, the average thickness value of the protective layer was measured by measuring the thicknesses of the protective layer at the five selected points or for 100 particles. Then, the thickness standard deviation for the entire sample was calculated and divided by the average thickness of the protective layer, thereby determining the ratio of thickness standard deviation to the average thickness. The results are shown in Table 1 below.

In addition, for Examples 3 and 4 which include the titania protective layer including a clustered structure consisting of multiple particles, the thickness of the protective layer formed by the aggregation of particles was measured in the same manner as described above, and the ratio of thickness standard deviation to the average thickness was calculated.

**[Table 1]**

| Sample (radical scavenger) | Reference Example | Example 1-1 | Example 1-2 | Example 1-3 | Example 2 | Example 3 | Example 4 |
|---|---|---|---|---|---|---|---|
| Protective layer | Carbon protective layer | Carbon protective layer | Carbon protective layer | Carbon protective layer | Silica protective layer | Titania protective layer | Titania-silica protective layer |
| Ratio (%) of thickness standard deviation to average thickness of protective layer | 6.90% | 1.57% | 1.59% | 1.28% | 1.74% | 1.98% | 1.87% |

Referring to Table 1 above, it was shown that, in the radical scavengers of Examples 1-1 to 1-3, in which the protective layer was formed uniformly, the ratio of thickness standard deviation to the average thickness of the protective layer was lower than that in the Reference Example in which the bulky protective layer was formed.

### [Production Example 2: Production of Membrane-Electrode Assemblies]

### <Membrane Electrode Assemblies of Comparative Example and Examples 1-1 to 1-3 and 2 to 4>

### Step of preparing electrode slurry

100 parts by weight of a commercial Pt/C catalyst from Tanaka Inc. and 100 parts by weight of a binder (a solid fluorinated resin) were placed in a reaction vessel and dissolved in a solvent (water), thereby preparing a catalyst dispersion. To the catalyst dispersion, each of the radical scavengers of Production Example 1 were added in an amount of 5 parts by weight based on 100 parts by weight of the Pt/C catalyst, thereby preparing a mixture. The mixture was dispersed with a homogenizer at 6,000 rpm for 30 minutes, thereby preparing an electrode slurry having a total solid content of 15 wt%.

### Step of preparing polymer electrolyte membrane

A polymer electrolyte membrane was prepared by applying a first ionomer dispersion (20 wt%, Nafion D-2020) onto a glass substrate, followed by drying at 120°C for 6 hours and heat treatment at 160°C for 1 hour.

### Step of producing membrane-electrode assembly

A catalyst layer was prepared by coating a release film with the electrode slurry, followed by drying at 60°C for 4 hours. The prepared catalyst layer was transferred onto both sides of the polymer electrolyte membrane at 150°C and 1 MPa for 2 minutes, thereby producing a membrane-electrode assembly.

### <Example 5: Production of Membrane-Electrode Assembly Additionally Including Interfacial Bonding Layer, Unlike Example 4>

### Preparation of composition for forming interfacial bonding layer

To a Nafion D-520 dispersion, CeO₂ of Example 4 having an average diameter (D₅₀) of 60 nm and including the titania-silica protective layer was added in an amount of 2 parts by weight based on 100 parts by weight of the total solid content of the dispersion, followed by stirring with a stirrer at 4,500 rpm for 30 minutes, thereby preparing a composition for forming an interfacial bonding layer.

### Step of preparing membrane-electrode assembly

The polymer electrolyte membrane prepared by the method according to Example 4 was placed on a heating plate heated to 120°C, and then one surface of the polymer electrolyte membrane was spray-coated with the composition for forming an interfacial bonding layer to form an interface bonding layer (thickness: 600 nm).

A catalyst layer was prepared by coating a release film with the electrode slurry, followed by drying at 60°C for 4 hours. The prepared catalyst layer was transferred onto both sides of the polymer electrolyte membrane at 150°C and 1 MPa for 2 minutes, thereby producing a membrane-electrode assembly.

### <Example 6: Production of Membrane-Electrode Assembly Including Radical Scavenger in Electrolyte Membrane, Unlike Example 4>

### Preparation of composition for forming polymer electrolyte membrane

To a Nafion D-2020 dispersion, the radical scavenger (CeO₂ including the titania-silica protective layer) of Example 4 having an average diameter (D₅₀) of 60 nm was added in an amount of 2 parts by weight based on 100 parts by weight of the total solid content of the dispersion, followed by stirring with a stirrer at 4,500 rpm for 30 minutes, thereby preparing a composition for forming a polymer electrolyte membrane.

### Step of preparing polymer electrolyte membrane

The composition for forming a polymer electrolyte membrane was applied onto a glass substrate, and then dried at 120°C for 6 hours and heat-treated at 160°C for 1 hour, thereby preparing a polymer electrolyte membrane.

A membrane-electrode assembly was produced in the same manner as in Example 4 above.

### <Example 7: Production of Membrane-Electrode Assembly Additionally Including Interfacial Bonding Layer on Electrolyte Membrane, unlike Example 4>

An interfacial bonding layer was formed on one surface of the polymer electrolyte membrane of Example 6 in the same manner as in Example 5, and a membrane-electrode assembly was produced in the same manner as in Example 4.

### [Experimental Example 2: Evaluation of Chemical Durability]

Table 2 below shows the results of measuring the voltage retention rate after 500 hours by performing the OCV retention method for the membrane-electrode assemblies of the Comparative Example, the Reference Example, and Examples 1-1 to 1-3 and 2 to 7 based on the chemical durability evaluation protocol of the U.S. Department of Energy (DOE). It can be confirmed that, when there was no protective layer, the voltage retention rate decreased sharply, whereas when the protective layer was used, the voltage retention rate remained stable with almost no change.

**[Table 2]**

| Sample (MEA) | Comp. Exam ple | Ref. Exampl e | Exampl e 1-1 | Exampl e 1-2 | Exampl e 1-3 | Exampl e 2 | Exampl e 3 | Exampl e 4 | Exampl e 5 | Exampl e 6 | Exampl e 7 |
|---|---|---|---|---|---|---|---|---|---|---|---|
| Protecti ve layer | NA | Bulky carbon protecti ve layer | Carbon protecti ve layer | Carbon protecti ve layer | Carbon protecti ve layer | Silica protecti ve layer | Titania protecti ve layer | Titania-silica protecti ve layer | Titania-silica protecti ve layer | Titania-silica protecti ve layer | Titania-silica protecti ve layer |
| Interfaci al bonding layer | X | X | X | X | X | X | X | X | O | X | O |
| Electrol yte membra ne | X | X | X | X | X | X | X | X | X | O | O |
| OCV retentio n (%@ 500 hr) | 76% | 77% | 95% | 90% | 91% | 93% | 90% | 94% | 96% | 95% | 98% |

Referring to Table 2 above, it can be confirmed that, in the Reference Example in which the ratio of thickness standard deviation to the average thickness of the protective layer exceeded 5%, the bulky carbon protective layer was formed, indicating that the radical scavenger did not exhibit its function. As a result, the membrane-electrode assembly including the radical scavenger according to the Reference Example showed a problem in that the voltage retention rate after 500 hours decreased sharply. On the other hand, it can be confirmed that, in Example 1-1 in which the ratio of thickness standard deviation to the average thickness of the protective layer satisfies 5% or less, the carbon protective layer could be formed uniformly, and accordingly, the chemical durability of the membrane-electrode assembly was further improved compared to that of the Reference Example.

When comparing Examples 1-1 to 1-3 in terms of chemical durability depending on the type of radical-scavenging particle, Example 1-1, in which CeO₂ was used as the radical-scavenging particle, showed further improved chemical durability compared to Example 1-2, in which MnO₂ was used as the radical-scavenging particle, and Example 1-3, in which Pt nanoparticles were used.

Although preferred embodiments of the present disclosure have been disclosed herein and specific terms have been used herein, they are used only in a general sense to facilitate the explanation of the technical content of the present disclosure and to aid in understanding the present disclosure, but are not intended to limit the scope of the present disclosure. It will be obvious to those skilled in the art to which the present disclosure pertains that, in addition to the embodiments disclosed herein, other modifications based on the technical concept of the present disclosure are possible. For example, those skilled in the art will appreciate that the radical scavenger, membrane-electrode assembly, fuel cell, and method of producing the same according to the embodiment described with reference to Figs. 1 to 17 can be modified in various ways. Therefore, the scope of the present disclosure should not be determined by the described embodiments, but by the technical concept described in the claims.

### [Description of Reference Numerals]

10: radical-scavenging particle
20, 20a, 20A, 20b, 20B, 20c, 20C: protective layer
20': preliminary protective layer
21: first material layer
22: second material layer
23: third material layer
50, 50a, 50A, 50b, 50B, 50c, 50C: radical scavenger
110: first electrode
115: first interfacial bonding layer
120: second electrode
125: second interfacial bonding layer
130: polymer electrolyte membrane
200: fuel cell

## Claims

1. A radical scavenger comprising:
a radical-scavenging particle; and
a protective layer formed on a surface of the radical-scavenging particle,
wherein a ratio of thickness standard deviation to an average thickness of the protective layer is 5% or less.

2. The radical scavenger according to claim 1, wherein the protective layer comprises a titania layer having a multilayer structure.

3. The radical scavenger according to claim 1, wherein the protective layer comprises at least two of a titania layer, a silica layer, and a carbon-based material layer.

4. The radical scavenger according to claim 1, wherein the protective layer has a porous structure.

5. The radical scavenger according to claim 1, wherein the protective layer has a thickness of 0.05 nm or more and 20 nm or less.

6. The radical scavenger according to claim 1, wherein the protective layer is formed using a vapor adsorption method of vaporizing a predetermined precursor and adsorbing the precursor or a component decomposed from the precursor onto the surface of the radical-scavenging particle.

7. A method for producing a radical scavenger, comprising:
a step of providing a radical-scavenging particle; and
a step of forming a protective layer from a predetermined precursor on a surface of the radical-scavenging particle using a vapor adsorption method of vaporizing the predetermined precursor and adsorbing the precursor or a component decomposed from the precursor onto the surface of the radical-scavenging particle.

8. The method for producing a radical scavenger according to claim 7, wherein the precursor has a vaporization temperature of 60°C or higher and 250°C or lower.

9. The method for producing a radical scavenger according to claim 7, wherein the protective layer comprises at least one of titania, silica, and carbon-based material.

10. The method for producing a radical scavenger according to claim 9, wherein the carbon-based material further comprises at least one heteroatom selected from among nitrogen (N), phosphorus (P), and sulfur (S).

11. The method for producing a radical scavenger according to claim 7, wherein
the protective layer comprises titania, and
the precursor comprises, as a precursor for forming the titania, at least one of titanium tetra-isopropoxide, titanium ethoxide, titanium methoxide, and titanium tetrachloride.

12. The method for producing a radical scavenger according to claim 7, wherein
the protective layer comprises silica, and
the precursor comprises, as a precursor for forming the silica, at least one of tetraethyl orthosilicate and tetramethyl orthosilicate.

13. The method for producing a radical scavenger according to claim 7, wherein
the protective layer comprises carbon-based material, and
the precursor comprises, as a precursor for forming the carbon-based material, at least one of phenol-formaldehyde resin, urea-formaldehyde resin, and pyrrole.

14. The method for producing a radical scavenger according to claim 7, wherein the step of forming the protective layer comprises:
a step of forming a preliminary protective layer from the precursor; and
a step of forming the protective layer from the preliminary protective layer by performing a heat treatment process on the preliminary protective layer.

15. A membrane-electrode assembly comprising:
a first electrode;
a second electrode spaced apart from the first electrode;
a polymer electrolyte membrane disposed between the first electrode and the second electrode; and
a radical scavenger provided on at least one of the first electrode, the second electrode and the polymer electrolyte membrane,
wherein the radical scavenger has a configuration set forth in claim 1.

16. The membrane-electrode assembly according to claim 15, further comprising
an interfacial bonding layer (IBL) disposed in at least one of between the first electrode and the polymer electrolyte membrane and between the second electrode and the polymer electrolyte membrane,
wherein the interfacial bonding layer comprises the radical scavenger.

17. A fuel cell comprising the membrane-electrode assembly set forth in claim 15.
